# EUROPEAN PATENT APPLICATION

(11) **EP 2 141 258 A1**
(43) Date of publication of application: **06.01.2010**
(21) Application number: 08159243.8
(22) Date of filing: 27.06.2008
(51) Int. Cl.: C23C 14/56

(54) **Processing system and method of operating a processing system**

(71) Applicant: Applied Materials, Inc., Santa Clara, CA 95054 (US)
(72) Inventor: Koparal, Erkan, 61130 Nidderau (DE); Lindenberg, Ralph, 63654 Büdingen (DE); Berger, Thomas, 55585 Norheim (DE)
(74) Representative: Lermer, Christoph

(57) **Abstract**

A coating system 1 comprises a swing station 2 including a swing module and an arrangement of chambers. The arrangement of chambers comprises a lock chamber 3 and a first coating chamber 4. The lock chamber 3 is configured as a combined lock-in/lock-out chamber. The arrangement of chambers has a first substantially linear transport path T1 indicated by dashed lines, and a second substantially linear transport path T2 indicated by dashed lines. The arrangement of the paths T1 and T2 establishes a dual track. The system 1 includes a transport system for moving a substrate through the arrangement of chambers 3, 4 along the first transport path T1 and/or along the second transport path T2 as indicated by arrows. One or particularly both chambers 3 and 4 comprise transfer means for transferring the substrate/carrier from the first path T1 to the second path T2 by a lateral movement and/or from the second path T2 to the first path T1.

## Description

### TECHNICAL FIELD

The present invention relates to a processing system for processing a substrate, comprising: an arrangement of chambers including at least a first process chamber for depositing a first layer on a substrate; at least a lock chamber configured for locking said substrate in said arrangement of chambers and/or locking a substrate out of said arrangement of chambers; and a first substantially linear transport path for transporting said substrate from said lock chamber into said first process chamber. Furthermore, the present invention relates to a method of operating a processing system as mentioned above.

### PRIOR ART

In a number of technical applications multiple layer stacks are deposited on a substrate in a sequence of coating steps. For example, in a TFT (Thin Film Transistor) metallization process two or three different metals are deposited by a sputtering process. Due to different coating rates in different process steps and due to different thickness of the layers the processing time in the coating stations for depositing different layers may vary considerably.

In order to deposit a multiple layer stack a number of configurations of coating and treatment chambers have been suggested. For example, in-line arrangements of coating chambers are used as well as cluster arrangements of coating chambers. A typical cluster arrangement comprises a central handling chamber and a number of coating chambers connected thereto. The coating chambers may be equipped to carry out the same or different coating processes. However, whereas in in-line systems the handling of the process is quite easy, the processing time is determined by the longest processing time. Therefore, the efficiency of the process is affected. Cluster tools, on the other hand, allow for different cycle times. However, the handling may be quite complex which requires an elaborate transfer system provided in the central handling chamber.

An alternative concept which combines in-line and cluster concepts has been described in document EP 1 801 843 A1 the content of which is incorporated herein be reference. The document describes a coating system for depositing a TFT layer stack having a lock-in chamber, a metallization station for a first metallization process, a central handling chamber, two metallization stations for a second metallization process, and a second metallization station for the first process. The metallization chambers for the second process are arranged parallel to each other and used alternatively. The process chambers for the first metallization process are arranged in-line such that every substrate is processed in both chambers. The cycle time of the system is reduced by the combination of an in-line and a cluster concept as the combination minimizes handling complexity while increasing the throughput.

European patent application EP 07 002 828.7 (not published) the content of which is incorporated herein be reference refers to a transport means provided in a coating station having transport segments configured as combination segments which may alternately be positioned in a transport position. One of the segments may be moved in a treatment position while the other segment is moved in the transport position.

However, all of the systems described above have some disadvantages. First, the systems require quite complex and expensive modules like e. g. rotational modules. Second, the throughout and efficiency of the systems is limited by their design.

### OBJECT OF THE INVENTION

It is an object of the present invention to increase the overall throughput and the efficiency of a coating system and to provide a method of processing a substrate which uses the components efficiently while avoiding the use of expensive and complex components.

### TECHNICAL SOLUTION

This object is solved by providing a processing system according to claim 1, and a method of operating a processing system according to claim 15. The dependent claims refer to preferred features of the invention.

A processing system for processing a substrate according to the invention comprises: An arrangement of chambers including at least a first process chamber for depositing a first layer on a substrate; at least a lock chamber configured for locking said substrate in said arrangement of chambers and/or locking a substrate out of said arrangement of chambers; and a first substantially linear transport path for transporting said substrate from said lock chamber into said first process chamber. Furthermore, the processing system comprises a second substantially linear transport path for transporting said substrate from said first process chamber into said lock chamber, wherein said second transport path is laterally offset relative to said first transport path.

The processing system is, for example, a coating system for depositing one or a plurality of layers on a substrate. The substrate may be transported through the system either without a carrier or attached to a carrier in order to be processed. The inventive coating system has two transport paths which are substantially linear. A linear transport path means an in-line path on which the substrate, the substrate carrier (particularly a substrate carrier having a substrate attached thereto) may be transported without a need to rotate the substrate/carrier in order to change the lateral position of the substrate/carrier or to displace the substrate/carrier laterally. On the other hand, the linear path may include deviations of the direction of the transport path from a straight line.

The first transport path and the second transport path may be arranged parallel. The first transport path and the second transport path extend from the inside of the lock chamber into the first process chamber. It is a feature of the present invention that the first transport path and the second transport path are laterally offset. They do not intersect and they are not connected e.g. by a rotation module. The substrate may only be transported between the transport paths by means of a translational movement. In other words, the surface of the substrate which is to be coated is always adjusted to the same side of the in-line system. Consequently, the processing tools are arranged on the same side relative to the first transport path and the second transport path.

The first transport path and the second transport path form a dual path or a dual track. The dual track extends from the combined lock-in/lock-out chamber into the processing chambers, which may be, for example, a coating chamber for depositing a No layer of a TFT device. The lock chamber is a combined lock-in and lock-out chamber. The lock chamber is a double track load/unload lock module. The substrates may be transported into the load lock from the arrangement of coating/process chambers as well as from a load station (e.g. swing station) for loading substrates to be coated. The load lock may be evacuated and vented, respectively. For example, before a substrate is transported into the load lock from the arrangement of coating/process chambers the lock-in/lock-out chamber is evacuated. Before a substrate is transported into the load lock from the load station for loading substrates the lock-in/lock-out chamber is vented. The same happens when a substrate is transported out the load lock chamber into the arrangement of coating/process chambers and the load station for loading substrates, respectively.

The lock-in/lock-out chamber/module may be a dual track module or a multi track module providing two or a plurality of positions for substrates received in the chamber. It may be a buffer chamber and/or a lock chamber which may be evacuated by means of a vacuum system.

In a preferred embodiment of the invention the arrangement of chambers comprises a second process chamber coupled in line with the first process chamber, wherein the first substantially linear transport path extends from the first process chamber into the second process chamber for transporting the substrate from the first process chamber into the second process chamber or from the second process chamber into the first process chamber, and the second substantially linear transport path extends from the first process chamber into the second process chamber for transporting the substrate from the second process chamber into the first process chamber or from the first process chamber into the second process chamber.

The first process chamber may be e.g. Mo coating station, the second process chamber may be e.g. an A1 coating station. Between the first process chamber and the second process chamber there may be one or various other process chambers, buffer chambers, transfer chambers, etc. However, the first transport path and the second transport path both extend linearly through these intermediate chambers.

The lock chamber, the first process chamber and the second process chamber are arranged in-line with each other.

It is preferred that the arrangement of chambers comprises a transfer chamber coupled in-line with the first process chamber and/or the second process chamber. Of course, the transfer chamber is also arranged in-line with the lock chamber.

In a preferred embodiment of the invention the first substantially linear transport path extends from the second process chamber into the transfer chamber for transporting the substrate from the second process chamber into the transfer chamber or from the transfer chamber into the second process chamber, and the second substantially linear transport path extends from the transfer chamber into the second process chamber for transporting the substrate from the transfer chamber into the second process chamber or from the second process chamber into the transfer chamber. It is possible that in this configuration the transfer chamber is arranged between the first process chamber and the second process chamber, or coupled to the second process chamber on the side averted from the first process chamber.

It is preferred that the first substantially linear transport path extends from the first process chamber into the transfer chamber for transporting the substrate from the first process chamber into the transfer chamber or from the transfer chamber into the first process chamber, and the second substantially linear transport path extends from the transfer chamber into the first process chamber for transporting the substrate from the transfer chamber into the first process chamber or from the first process chamber into the transfer chamber. In this configuration the transfer chamber may be coupled to the first process chamber on a side averted from the lock chamber, and, if there is a second process chamber, arranged between the first process chamber and the second process chamber.

The processing system may comprise a transport system for transporting a substrate along the first transport path and along the second transport path. During the transport along the transport path the substrates may be supported in a substrate carrier. The substrates may be attached to the substrate carrier. In another embodiment the substrates may pass through the coating system without a carrier, e. g. by means of an air cushion transport system. The transport system is configured to transport the substrate and/or the substrate carrier along the transport paths, at least between the lock chamber, the first coating chamber, the second coating chamber, and/or the transfer chamber.

The transport system may comprise at least a guidance for guiding a substrate along the first transport path and/or along the second transport path. The term substrate is used for substrate and/or for substrate carrier. The guidance may comprise a rail (usually arranged at the bottom and/or at the top of the chamber; provided that substrates are aligned vertically or at least inclined during the transport through the processing system). The guidance may comprise a magnetic guiding system which is usually arranged at the top of the vertically aligned substrate. However, any other transport system may be used in connection with the invention. Furthermore, the substrate may be transported in any alignment.

In a preferred embodiment of the invention the transport system comprises a first guidance for guiding the substrate along the first transport path and a second guidance for guiding the substrate along the second transport path.

It is preferred that at least one of the first process chamber, the second process chamber and the transfer chamber comprises means for transferring the substrate from the first transport path to the second transport path and/or from the second transport path to the first transport path. The means may comprise a roller drive, a gear drive, a hydraulic or pneumatic drive, etc. The transfer movement may be a vertical or a horizontal movement. It is a translational movement without any rotation of the substrate/carrier.

The means for transferring the substrate may include a transfer device for laterally displacing the substrate from the first transport path to the second transport path and/or from the second transport path to the first transport path. The transfer device may include e. g. a lifting device. The process chamber(s) and/or the lock chamber and/or the transfer chamber(s) may comprise a transfer device. In this way complex and expensive rotation modules may be dispensed with. The alignment of the substrate/carrier remains unchanged during the entire transport of the substrate/carrier from the combined lock-in/lock-out chamber through the system and back into the combined lock-in/lock-out chamber.

The means for transferring the substrate may include a transfer device for laterally displacing a section of the guidance from the first transport path to the second transport path and/or from the second transport path to the first transport path. This means that a section of the guidance is arranged either in the first transport path or in the second transport path to complete one of the first transport path and the second transport path. The section of the guidance may be a rail section which is laterally displaceable. The section is arranged in one of the chambers. The means for transferring the substrate is constructed to move a substrate, a substrate carrier, and/or a rail section from the first transport path to the second transport path.

It is preferred that the means for transferring the substrate includes a combination of at least a first guidance section and a second guidance section, wherein the first guidance section is arranged parallel with the second guidance section in a distance corresponding to the distance between the first transport path and the second transport path, and a transfer device for laterally displacing the combination for moving a substrate from the first transport path to the second transport path and vice versa. The combination may be configured as at least two parallel transport segments, one of which may be positioned in the first transport path or in the second transport path, and the other one in the second transport path, in the first transport path and in a third position, respectively. One of the rail segments may be moved in a position along the first transport path while the other segment may be moved in a position along the second transport path. The combination may be a dual track section with two track sections arranged parallel besides each other. In this embodiment of the invention the dual track section is laterally moveable, particularly transverse and/or in a direction perpendicular to the transport path.

In a preferred embodiment of the invention the first process chamber and/or the second process chamber include processing tools arranged in the respective process chamber laterally besides the first transport path. This arrangement is a consequence of the fact that a first surface of the substrate moving along the first transport path and the second transport path is always aligned in a direction towards the processing tools irrespective whether it moves along the first transport path or the second transport path. In this arrangement processing/coating tools are arranged at one side of the in-line arrangement, and only on this side. The substrate/carrier is never rotated when moving within the arrangement of chambers. Therefore it is not necessary to provide processing/coating tools on the other side of the in-line arrangement.

The arrangement of chambers may include at least a third process chamber coupled in line with the first process chamber and/or the second process chamber.

According to the invention, a method of operating a processing system as described above comprises the steps of: a) transporting a first substrate from the lock chamber into the first process chamber along the first transport path, and depositing a first layer on the first substrate; b) laterally transferring the first substrate from the first transport path to the second transport path; and c) transporting the first substrate into the lock chamber along the second transport path.

The first surface of the substrate is directed to the same side of the in-line arrangement during the complete process.

It is preferred that the method comprises transporting a second substrate from the lock chamber into the first process chamber along the first transport path during the method step c).

The method may include transferring the first substrate being processed at least once from the first transport path to the second transport path in order to enable a second substrate to pass the first substrate along the first transport path. The arrangement of chambers may include at least a transfer chamber for transferring the substrate from the first transport path to the second transport path and vice versa.

Another process in a configuration as described above may be outlined as follows. A first substrate is locked in the coating system via the lock-in/lock-out module. Afterwards the substrate is processed to receive a first layer, e.g. Mo1 layer, in the first process chamber. Then the substrate is transported into the second process chamber to obtain a second layer, e.g. an A1 layer, before being transported back into the first chamber to obtain a third layer, e.g. a Mo2 layer, on top of the second layer. The second layer is much thicker than the first and the third layer. Therefore, the first chamber is used twice in processing one substrate while the second process chamber is used once during the process. After the A1 coating process a second substrate coming from the first chamber passes the first substrate and obtains an A1 layer in the second layer, and the first substrate obtains a Mo2 layer in the first chamber.

The method described above is sequentially repeated. The substrates pass the process stations sequentially.

By means of the invention, a high throughput of the coating system may be achieved, while a complex construction and the inclusion of complex rotational modules may be avoided. Furthermore, the installation space needed for the arrangement of the coating system may be reduced.

A dual track configuration as described may be applied to a plurality of different layouts of arrangements of process/handling modules. The features described above are claimed per se in any combination thereof.

### BRIEF DESCRIPTION OF THE DRAWING(S)

Further features and advantages of the invention will be apparent from the following description of preferred embodiments with reference to the appended drawings. The figures illustrate
- Figure 1: a first embodiment of a processing system according to the present invention;
- Figure 2: a second embodiment of a processing system according to the present invention;
- Figure 3: a third embodiment of a processing system according to the present invention in a first operational mode;
- Figure 4: the third embodiment of Fig. 3 in a second operational mode;
- Figure 5: a fourth embodiment of a processing system according to the present invention;
- Figure 6: a fifth embodiment of a processing system according to the present invention; and
- Figure 7: a sixth embodiment of a processing system according to the present invention.

### DETAILED DESCRIPTION OF PREFERRED EMBODIMENTS

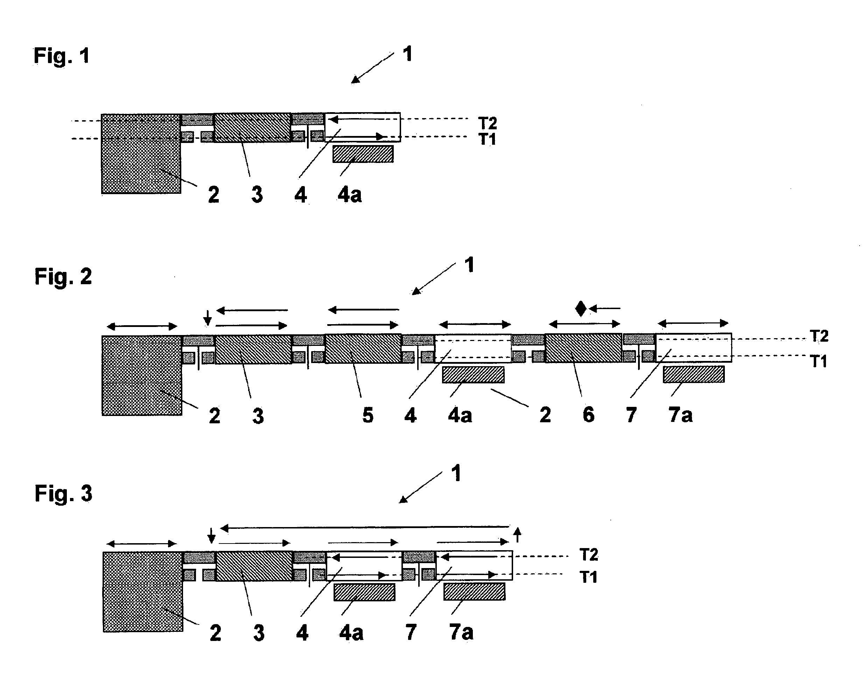

Figure 1 illustrates a first embodiment of a coating system 1 according to the present invention. The system 1 comprises a substrate feeding and receiving station (e. g. a swing station) 2 including a swing module which is operated in atmospheric pressure for feeding substrates into an arrangement of chambers and/or for receiving substrates processed in the coating system 1 from the arrangement of chambers.

The first embodiment of the invention corresponds to an arrangement of chambers which comprises a lock chamber 3 and a first coating chamber 4. The lock chamber 3 is configured as a combined lock-in/lock-out chamber. The first coating chamber 4 is equipped with coating tools 4a for depositing a layer on a substrate.

The arrangement of chambers consisting of the lock chamber 3 and the first coating chamber 4 has a first substantially linear transport path T1 indicated by dashed lines, and a second substantially linear transport path T2 indicated by dashed lines. The first transport path T1 and the second transport path T2 are arranged parallel without an intersection therebetween. The arrangement of the paths T1 and T2 establishes a dual track.

The system 1 includes a transport system for moving a substrate through the arrangement of chambers 3, 4 along the first transport path T1 and/or along the second transport path T2 as indicated by arrows. Particularly, a substrate is transported from the swing station 2 into the lock chamber 3 along the first path T1 and afterwards into the first coating chamber 4 along the first path T1. In this first position, the coating tools 4a are activated for depositing a material layer on the substrate. Afterwards, the substrate is transferred into a second position within first coating chamber 4 by means of a first displacement device (indicated by a doubleheaded arrow). The second position is located on the second transport path T2. Afterwards, the substrate is transported back into the lock chamber 3, transferred into a third position within the lock chamber 3 by means of a second displacement device (indicated by a doubleheaded arrow) and further into the swing station 2. The third position is located on the first transport path T1.

As soon as the substrate has been transferred into a position located along the second transport path T2, a second substrate may enter the arrangement of chambers 3, 4, and particularly the coating chamber 4 in order to be processed. This sequence may be repeated continuously, thereby providing a continuous flow of substrates through the system 1.

One or particularly both chambers 3 and 4 comprise transfer means for transferring the substrate/carrier from the first path T1 to the second path T2 by a lateral movement and/or from the second path T2 to the first path T1.

The transfer means may comprise an actuator which moves a single track section (e.g. rail section) provided in one of the chambers 3 or 4 between the first path T1 and the second path T2. Alternatively, the transfer means comprises a dual track section (dual rail section) configured as a combination of two track section being spaced apart to form a part of the first track T1 and the second track T2, respectively. The combination is laterally movable such that the track section corresponding to the first transport path T1 may be moved in a position along the second transport path T2. In another embodiment of the invention the transfer means may comprise a lift device for lifting the substrate from a position along the first transport path T1 laterally into a position along the second transport path T2. The invention is not meant to be limited to particular transfer means.

Figure 2 discloses a second embodiment of the present invention wherein the same reference numerals and symbols denote the same elements as described in connection with the first embodiment.

The system 1 according to the second embodiment comprises a buffer chamber 5 arranged between a lock chamber 3 and a first coating chamber 4. Furthermore, it comprises a transfer chamber 6 and a second coating chamber 7 having second coating tools 7a for depositing a second layer on a substrate. The transfer chamber 6 and the second coating chamber 7 form a linear arrangement of chambers together with the lock chamber 3, the buffer chamber 5 and the first coating chamber 4. It can been seen that both the first coating tools 4a and the second coating tools 7a are arranged on the same side of the in-line arrangement of the system 1 along the first transport path T1.

A method of operating the system 1 may include transporting a first substrate along the first transport path T1 from the lock chamber 3 into the buffer chamber 5 and into the first process chamber 4 wherein a first material layer is deposited on a first surface of the first substrate. Then the first substrate is transported into the transfer chamber 6 and into the second coating chamber 7. In the second coating chamber 7 a second material layer is deposited on top of the first material layer. Afterwards, the substrate is transported back into the transfer chamber 6.

In the transfer chamber 6 the first substrate is transferred from a position on the first transport path T1 into a position on the second transport path T2 by transfer means as described above. This is indicated by double headed arrows in the transfer chamber 6. After this, a second substrate is received in the transfer chamber 6 from the first coating chamber 4 and transported into the second coating chamber 7 along the first transport path T1. Afterwards, the first substrate is transferred from the position along the second transport path T2 back into a position along the first transport path T1 and into the first coating chamber 4. In the first coating chamber 4 the first substrate receives a third material layer on top of the first material layer and the second material layer. Afterwards, the substrate is transported into the buffer chamber 5 wherein it is transferred into a position along the second transport path T2 in order to allow a third substrate to pass into the first coating chamber 4 along the first transport path T1. The first substrate leaves the processing system 1 via the lock chamber 3 along the second transport path T2. The sequence described in connection with a first, a second and a third substrate is repeated continuously to provide a sequential process.

Figure 3 illustrates a third embodiment of a coating system 1 according to the present invention. In an operational mode for depositing two layers on a substrate a first substrate is transported via the lock chamber 3 along the first transport path T1 into the first coating chamber 4. In the first coating chamber 4 a first layer is deposited on the surface of the first substrate. Afterwards, the first substrate is transported into the second coating chamber 7 for the deposition of a second layer on top of the first layer. Afterwards, the first substrate is transferred into a position along the second transport path T2 to generate space along the first transport path T1 for a second substrate to enter the second coating chamber 7. The first substrate is transported back via the first process chamber 4 and the lock chamber 3 along the second transport path T2. In the lock chamber 3 the first substrate is transferred from the position along the second transport path T2 into a position along the first transport path T1 to exit the arrangement of chambers to the swing station 2.

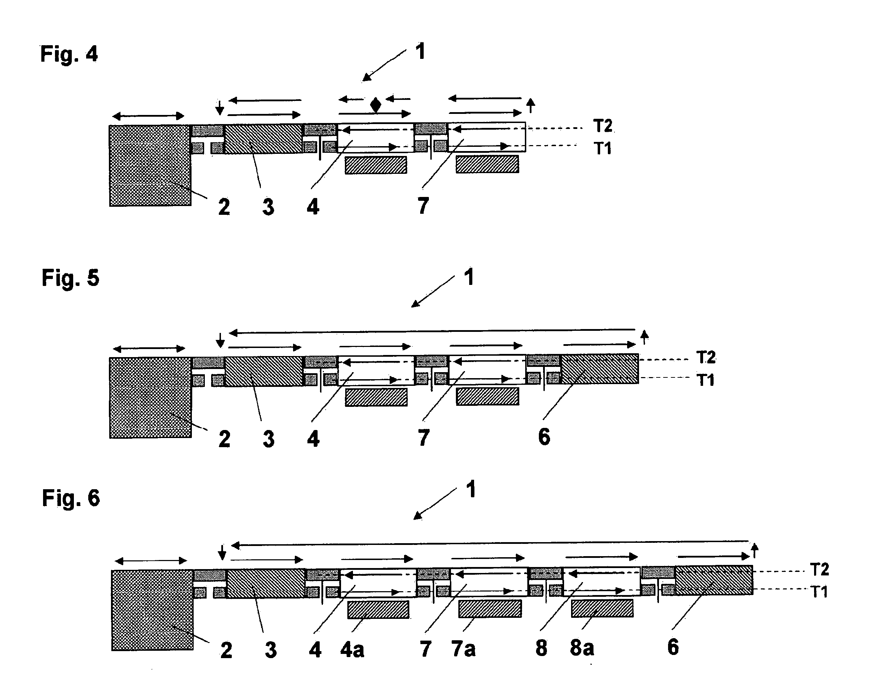

The same arrangement of chambers is disclosed in figure 4. However, in another operational mode three layers may be deposited on the surface of the substrate. A first substrate is transported via the lock chamber 3 into the first process chamber 4 for the deposition of a first coating layer on a first surface of the first substrate. Afterwards, the first substrate is transported into the second process chamber 7 for the deposition of a second layer on top of the first layer. Afterwards, the substrate is transferred into a position along the second transport path T2 for generating space for a second substrate to enter the second coating chamber 7 along the first transport path T1. Afterwards, the first substrate is transported back into the first coating chamber 4 and transferred therein from a position along the second transport path T2 into a position along the first transport path T1. In this position of the first substrate a third layer is deposited on top of the second layer. Afterwards, the first substrate is transferred back from the position along the first transport path T1 into a position along the second transport path T2 for generating space for a third substrate to enter the first coating chamber 4 along the first transport path T1. The first substrate is transported back into the lock chamber 3 and laterally displaced back to the first transport path T1 to exit the arrangement of chambers to the swing station 2. The second substrate, the third substrate, etc. follow the first substrate to generate a continuous flow of substrates through the system 1.

Compared with the third embodiment illustrated in figures 3 and 4 in a fourth embodiment of the invention is shown in figure 5. The system 1 comprises an additional transfer chamber 6 coupled to the second process chamber 7 to form an in-line arrangement of a lock chamber 3, a first process chamber 4, a second process chamber 7 and the transfer chamber 6.

In an operational mode where two layers are to be deposited on the surface of a substrate a first substrate is transported along the first transport path T1 to receive a first material layer and a second material layer in the first process chamber 4 and the second process chamber 7, respectively. Afterwards, the first substrate is transferred from the position along the first transport path T1 into a position along the second transport path T2 in the transfer chamber 6. A second substrate may follow the first substrate into the transfer chamber 6 along the first transport path T1. The first substrate is transported back into the lock chamber 3 along the second transport path T2 and then transferred in a position on the first transport path T1 to exit the system via the swing station 2.

Figure 6 illustrates an arrangement of chambers according to a fifth embodiment of a coating system 1 according to the present invention. In addition to the fourth embodiment, the coating system 1 includes a third process chamber 8 having third process tools 8a. The third process chamber 8 is arranged between the second process chamber 7 and the transfer chamber 6. Therefore, a substrate may pass through the system 1 along the first transport path T1 thereby receiving three material layers. In the transfer chamber 6 the substrate is transferred from the first transport path T1 to the second transport path T2 to travel back along the second transport path into the lock chamber 3, wherein it is transferred back to the first transport path T1 before exiting the system 1.

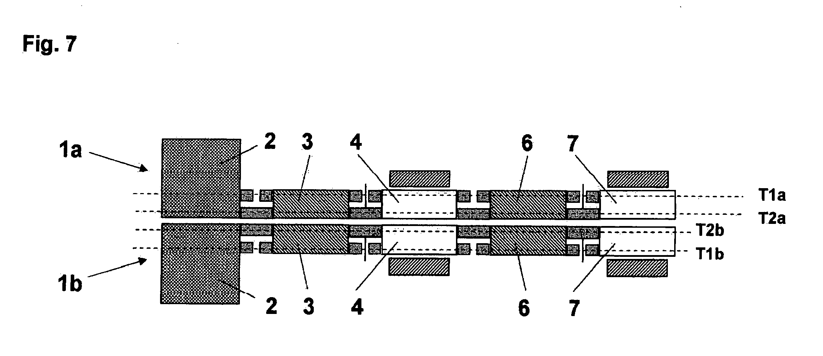

The system 1 according to figure 7 consists of two independent branches 1a and 1b, each of them having a first transport path T1a and a second transport path T2a and T2b, respectively.

Each branch comprises a swing station 2, a lock chamber 3, a first process chamber 4, a transfer chamber 6 and a second process chamber 7 arranged in-line. Each of the branches la, lb is operated by a method for providing two layers or three layers on a substrate.

In the two-layer operational mode a first substrate is transferred from a position along the first transport path T1a, T1b in a position along the second transport path T2a, T2b after having received the first material layer and the second material layer. Then the first substrate is transported back along the second transport paths T2a and T2b, respectively, while a second substrate follows the first substrate on the first transport path T1.

In a three-layer operational mode a second substrate passes the first substrate in the transfer chamber 6. Afterwards, the first substrate is transferred back onto the first transport path T1a, T1b and into the first coating chamber 4 for the deposition of a third material layer on top of the second material layer. Afterwards, the substrate may be transferred onto the second transport path T2a, T2b within the first coating chamber 4 for exiting the system 1 via the lock chamber 3 and the swing station 2. In the meantime, a third substrate may pass into the first process chamber 4 along the first transport path T1.

A typical application for depositing a layer stack on a substrate is (as an example only) includes depositing a first Mo layer of a thickness of 400 A on the substrate, depositing a second A1 layer of a thickness of 3500 A on top of the first layer, and depositing a third Mo layer of a thickness of 700 A on top of the second layer. The third layer is deposited in either the first coating chamber 4 or in the third coating chamber 8.

Various other configurations of chambers may be realized without departing from the concept according to the invention which includes having at least two transport paths T1 and T2 extending through the complete in-line arrangement extending through at least a lock chamber 3 and a first process chamber 4. By means of such system configurations it is possible to provide different operational modes to increase the efficiency of a coating system 1. Another advantage of using the dual track system 1 is that the number of venting/evacuation steps may be reduced, thus increasing the time available for the evacuation process. This is due to the fact that the load/unload lock chambers 3 have to be vented and evacuated only once for loading a first substrate and unloading a second substrate.

## Claims

1. A processing system (1) for processing a substrate, comprising:
an arrangement of chambers including at least a first process chamber (4) for depositing a first layer on said substrate;
at least a lock chamber (3) configured for locking said substrate in said arrangement of chambers and/or locking a substrate out of said arrangement of chambers; and
a first substantially linear transport path (T1) for transporting said substrate from said lock chamber (3) into said first process chamber (4);
**characterized in that**
said processing system (1) comprises a second substantially linear transport path (T2) for transporting said substrate from said first process chamber (4) into said lock chamber (3), wherein
said second transport path (T2) is laterally offset relative to said first transport path (T1).

2. The processing system (1) of claim 1,
**characterized in that**
said arrangement of chambers comprises a second process chamber (7) coupled in line with said first process chamber (4), wherein
said first substantially linear transport path (T1) extends from said first process chamber (3) into said second process chamber (7) for transporting said substrate from said first process chamber (4) into said second process chamber (7) or from said second process chamber (7) into said first process chamber (4), and
said second substantially linear transport path (T2) extends from said first process chamber (4) into said second process chamber (7) for transporting said substrate from said second process chamber (7) into said first process chamber (4) or from said first process chamber (4) into said second process chamber (7).

3. The processing system (1) of claim 1 or 2,
**characterized in that**
said arrangement of chambers comprises a transfer chamber (6) coupled in line with said first process chamber (4) and/or said second process chamber (7).

4. The processing system (1) of claim 3,
**characterized in that**
said first substantially linear transport path (T1) extends from said second process chamber (7) into said transfer chamber (6) for transporting said substrate from said second process chamber (7) into said transfer chamber (6) or from said transfer chamber (6) into said second process chamber (7), and
said second substantially linear transport path (T2) extends from said transfer chamber (6) into said second process chamber (7) for transporting said substrate from said transfer chamber (6) into said second process chamber (7) or from said second process chamber (7) into said transfer chamber (6).

5. The processing system (1) of claim 3 or 4,
**characterized in that**
said first substantially linear transport path (T1) extends from said first process chamber (4) into said transfer chamber (6) for transporting said substrate from said first process chamber (4) into said transfer chamber (6) or from said transfer chamber (6) into said first process chamber (4), and
said second substantially linear transport path (T2) extends from said transfer chamber (6) into said first process chamber (4) for transporting said substrate from said transfer chamber (6) into said first process chamber (4) or from said first process chamber (4) into said transfer chamber (6).

6. The processing system (1) of any of the previous claims,
**characterized in that**
said processing system (1) comprises a transport system for transporting a substrate along said first transport path (T1) and along said second transport path (T2).

7. The processing system (1) of claim 6,
**characterized in that**
said transport system comprises at least a guidance for guiding a substrate along said first transport path (T1) and/or along said second transport path (T2).

8. The processing system (1) of claim 7,
**characterized in that**
said transport system comprises a first guidance for guiding said substrate along said first transport path (T1) and a second guidance for guiding said substrate along said second transport path (T2).

9. The processing system (1) of any of the previous claims,
**characterized in that**
at least one of said first process chamber (4), said second process chamber (7) and said transfer chamber (6) comprises means for transferring said substrate from said first transport path (T1) to said second transport path (T2) and/or from said second transport path (T2) to said first transport path (T1).

10. The processing system (1) of claim 9,
**characterized in that**
said means for transferring said substrate includes a transfer device for laterally displacing said substrate from said first transport path (T1) to said second transport path (T2) and/or from said second transport path (T2) to said first transport path (T1).

11. The processing system (1) of claim 10,
**characterized in that**
said means for transferring said substrate includes a transfer device for laterally displacing a section of said guidance from said first transport path (T1) to said second transport path (T2) and/or from said second transport path (T2) to said first transport path (T1).

12. The processing system (1) of claim 10,
**characterized in that**
said means for transferring said substrate includes a combination of at least a first guidance section and a second guidance section, wherein said first guidance section is arranged parallel with said second guidance section in a distance corresponding to the distance between said first transport path (T1) and said second transport path (T2), and a transfer device for laterally displacing said combination for moving a substrate from said first transport path (T1) to said second transport path (T2) and vice versa.

13. The processing system (1) of any of the previous claims,
**characterized in that**
said first process chamber (4) and/or said second process chamber (7) include processing tools arranged in said respective process chamber laterally besides said first transport path (T1).

14. The processing system (1) of any of the previous claims,
**characterized in that**
said arrangement of chambers includes at least a third process chamber (8) coupled in line with said first process chamber (4) and/or the second process chamber (7).

15. A method of operating a processing system (1) according to any of the previous claims, comprising the steps of:
a) transporting a first substrate from said lock chamber (3) into said first process chamber (4) along said first transport path (T1), and depositing a first layer on said first substrate;
b) laterally transferring said first substrate from said first transport path (T1) to said second transport path (T2); and
c) transporting said first substrate into said lock chamber (3) along said second transport path (T2).

16. The method of claim 15,
**characterized in that**
said method comprises transporting a second substrate from said lock chamber (3) into said first process chamber (4) along said first transport path (T1) during said method step c).

17. The method of claim 15 or 16,
**characterized in that**
said method includes transferring said substrates being processed at least once from said first transport path (T1) to said second transport path (T2) in order to enable another substrate to pass the substrate along said first transport path (T1).
